# EUROPÄISCHE PATENTSCHRIFT

(11) **EP 0 676 055 B1**
(45) Veröffentlichungstag und Bekanntmachung des Hinweises auf die Patenterteilung: **16.10.1996**
(21) Anmeldenummer: 94902679.3
(22) Anmeldetag: 04.12.1993
(51) Int. Cl.: G01R 31/06, G01R 31/27, B60T 17/22

(54) **SCHALTUNGSANORDNUNG ZUR ÜBERWACHUNG EINER VIELZAHL VON SPULEN**
CIRCUIT ARRANGEMENT FOR MONITORING A PLURALITY OF COILS
AGENCEMENT DE CIRCUITS PERMETTANT DE SURVEILLER UNE PLURALITE DE BOBINES

(30) Priorität: 15.12.1992 DE 4242177
(43) Veröffentlichungstag der Anmeldung: 11.10.1995
(73) Patentinhaber: ITT Automotive Europe GmbH, 60488 Frankfurt (DE)
(72) Erfinder: LORECK, Heinz, D-65510 Idstein (DE); ZYDEK, Michael, D-35428 Langgöns (DE); TOTH, Tibor, D-65795 Hattersheim 1 (DE); THÖNE, Alois, D-61169 Friedberg (DE)
(74) Vertreter: Blum, Klaus-Dieter, Dipl.-Ing.
(86) Internationale Anmeldenummer: EP9303414
(87) Internationale Veröffentlichungsnummer: WO9414077

(56) Entgegenhaltungen:
- DE-A- 3 925 418
- DE-B- 2 701 159
- Patent Abstracts of Japan, Band 11, Nr 5(P-533); & JP,A,61182586 (ATOM ENERGY RES INST), 1986-08-15
- PATENT ABSTRACTS OF JAPAN, Band 11, Nr 5(P-533); & JP-A-61182586

## Beschreibung

Die Erfindung bezieht sich auf eine Schaltungsanordnung zur Überwachung einer Vielzahl von Spulen und der Endstufen zur Ansteuerung dieser Spulen, z.B. der Ventilspulen einer Bremsanlage mit Blockierschutz- oder Antriebsschlupfregelung, bei der die Spulen über eine gemeinsame Versorgungsleitung sowie über ein gemeinsames Relais an die Versorgungsspannung angeschlossen sind und bei der die Endstufen nach einem vorgegebenen Programm mit Testpulsen angesteuert werden und die Potentialänderung an den einzelnen Spulen-Ansteueranschlüssen festgestellt wird. Die Spulen werden durch diese Schaltung auf Funktionsfähigkeit, auf Nebenschlüsse, Leitungsunterbrechung und auf andere Defekte überwacht.

Aus der DE 39 25 418 A1 ist bereits eine derartige Schaltungsanordnung bekannt. Es werden die Endstufen, die zur Steuerung elektrisch betätigbarer Ventile dienen, nach einem vorgegebenem Schema mit kurzen Testpulsen beaufschlagt und die Reaktion auf die Testpulse festgestellt. Hierzu werden die Ansteueranschlüsse der einzelnen Ventile über eine Vergleichsschaltung und außerdem über eine ODER-Verknüpfung zusammengeführt. Die Vergleichsschaltung besteht aus einer Kette von Antivalenz- oder Äquivalenzgliedern. Die Ausgangssignale der Vergleichsschaltung und der ODER-Verknüpfung werden einem weiteren Vergleichselement zugeführt, dessen Ausgangssignal schließlich in Abhängigkeit von den Testpulsen zur Überwachung der Endstufen ausgewertet wird.

Der vorliegenden Erfindung liegt die Aufgabe zugrunde, eine solche Überwachungsschaltung derart auszulegen, daß Fehler der unterschiedlichsten Art, d.h. sowohl Kurzschlüsse, Nebenschlüsse, Leitungsunterbrechungen, aber auch Fehler der Überwachungskomponenten selbst, mit großer Zuverlässigkeit erkannt werden. Der für diese Überwachung erforderliche Aufwand sollte möglichst gering sein.

Es hat sich herausgestellt, daß diese Aufgabe mit einer Schaltungsanordnung der eingangs genannten Art gelöst werden kann, deren Besonderheit darin besteht, daß die Versorgungsleitung an einen ersten Potentialmonitor und über einen hochohmigen Widerstand an eine Prüfspannungsquelle angeschlossen ist, wobei mit dem ersten Potentialmonitor nach dem Unterbrechen der Spannungsversorgung bzw. nach dem Öffnen des Relais bzw. des Relaiskontaktes das auf der Versorgungsleitung herrschende Potential feststellbar ist.

Durch den Anschluß der Versorgungsleitung an eine Prüfspannungsquelle und Einfügen eines hochohmigen Widerstandes, durch das Unterbrechen der Spannungsversorgung während des Testens mit Hilfe des Relais und durch das Messen des in dieser Prüfphase auf der Versorgungsleitung herrschenden Potentials ist erkennbar, ob Leckströme auftreten und ggf. ob die Leckströme innerhalb oder außerhalb eines tolerierbaren Bereiches liegen. Je nach Höhe eines solchen Leckstromes sind unterschiedliche Reaktionen der Überwachungsschaltung - sofortiges Abschalten der Regelung, verzögertes Abschalten oder Aufrechterhaltung der Regelung - sinnvoll. Natürlich sind auch Kurzschlüsse zwischen der Versorgungsleitung oder der Spule und Masse, defekte Endstufen, defekte Ansteuerung und andere Fehler erkennbar.

Nach einem vorteilhaften Ausführungsbeispiel der Erfindung ist an die Versorgungsleitung ein zweiter Potentialmonitor angeschlossen, der beim Einschalten der Versorgungsspannung die ordnungsgemäße, durch die Relaisbetätigung ausgelöste Potentialänderung auf der Versorgungsleitung überwacht.

Zweckmäßigerweise sind die Spannungsmonitoren über Spannungsteiler an die Versorgungsleitung angeschlossen, um Spannungs- Toleranzbereiche festlegen zu können, die für einen ordnungsgemäßen Betrieb noch zulässig sind.

Die Verwendung eines Halbleiter-Relais zum Ein- und Ausschalten der Spannungsversorgung für die Spulen ist deswegen von besonderem Vorteil, weil solche Halbleiter-Relais sehr schnell auf Ansteuersignale reagieren. Dadurch wird es möglich, ohne Beeinträchtigung des ordnungsgemäßen Betriebs der Blockierschutz- oder Antriebsschlupfregelung das Testprogramm zu verschiedenen Zeitpunkten, auch während des normalen Betriebs, durchzuführen.

Als erster Potentialmonitor wird zweckmäßigerweise ein Analog/Digital-Wandler verwendet, um die Höhe der Potentialverschiebungen infolge von bestimmten Fehlern festzustellen und bewerten zu können.

Als zweiter Potentialmonitor ist nach einem Ausführungsbeispiel der Erfindung ein Fensterkomparator mit umschaltbarer Schwelle vorgesehen, wobei nach dem Einschalten der Versorgungsspannung durch entsprechende Betätigung des Relais und Überschreiten eines ersten Schwellwertes das Umschalten auf einen zweiten Schwellwert erfolgt und wobei dieses Umschalten als Kriterium für die ordnungsgemäße Funktion des Fensterkomparators ausgewertet wird. Außerdem kann auch die Potentialänderung am Eingang des ersten Potentialmonitors in Abhängigkeit von der Relaisbetätigung zum Überprüfen der Funktionsfähigkeit des ersten Potentialmonitors ausgewertet werden.

Schließlich besteht ein Ausführungsbeispiel der Erfindung noch darin, daß bei der Ansteuerung der einzelnen Endstufen durch die Testpulse die jeweilige Potentialänderung an den Spulen-Ansteueranschlüssen mit den Potentialänderungen am Eingang des ersten Potentialmonitors bzw. Analog/Digital-Wandlers verglichen und zur Überwachung sowie Fehlererkennung ausgewertet wird.

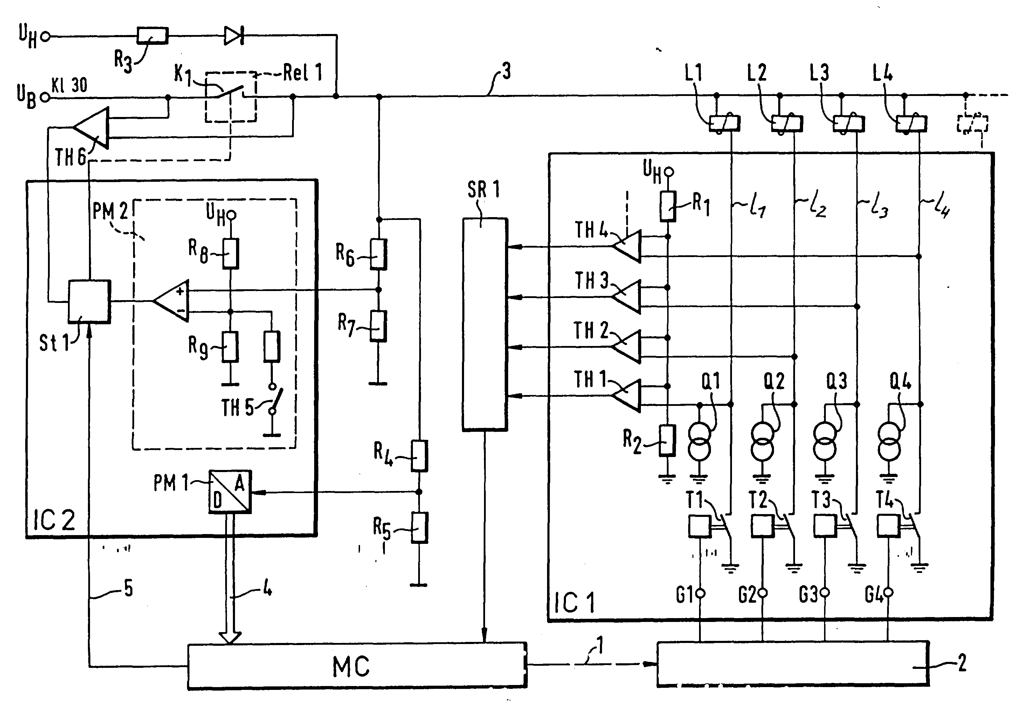

Weitere Merkmale, Vorteile und Anwendungsmöglichkeiten der Erfindung gehen aus der folgenden Beschreibung eines Ausführungsbeispiels der Erfindung anhand der beigefügten Abbildung vor, die schematisch vereinfacht und in Blockdarstellung die wichtigsten Komponenten einer Schaltungsanordnung nach der Erfindung wiedergibt.

Die dargestellte Schaltungsanordnung ist Bestandteil der elektronischen Regelschaltung einer Bremsanlage mit Blockierschutz- oder Antriebsschlupfregelung. Der Bremsdruck wird in solchen Bremsanlagen mit Hilfe von elektrisch oder elektromagnetisch betätigbaren Hydraulikventilen gesteuert, deren Spulen in der beigefügten Abbildung mit L1 bis L4 symbolisiert sind. Durch Strichelung ist angedeutet, daß im allgemeinen eine noch größere Anzahl von Ventilen und damit auch Ventilspulen (z.B. 8 oder 10) vorhanden sind.

Endstufen zum Ein- und Ausschalten des Erregerstromes für die Spulen L1 bis L4 sind durch Schalter oder Transistoren T1 bis T4 symbolisiert, die über die Anschlüsse G1 bis G4 angesteuert und damit betätigt werden. Mit Hilfe von Komparatoren TH1 bis TH4 wird festgestellt, ob das Potential am Ausgang der Schalter oder Transistoren T1 bis T4 bzw. am Ansteueranschluß l₁ bis l₄ der Spulen L1 bis L4 über oder unter einem vorgegebenen Schwellwert liegt, der mit Hilfe einer Hilfsspannung U_{H} und eines Spannungsteilers R₁, R₂ definiert wird. Bei geöffnetem Schalter T1 bis T4 wird das Potential an dem entsprechenden Eingang der Komparatoren TH1 bis TH4 durch einen hochohmigen Vorwiderstand oder durch Stromquellen Q1 bis Q4, festgelegt.

Die Schalter T1 bis T4, die Komparatoren TH1 bis TH4, der Spannungsteiler R₁, R₂ und die Stromquellen Q1 bis Q4 sind zweckmäßigerweise in einem gemeinsamen integrierten Schaltkreis IC1 untergebracht.

Die Ausgangspegel der Komparatoren TH1 bis TH4 werden über ein Schieberegister SR1 erfaßt und seriell zu einem Mikrocontroller MC weitergeleitet. In entsprechender Weise werden die Testpulse von dem Mikrocontroller MC über eine Leitung 1 und einen Wandler 2 den Steueranschlüssen G1 bis G4 der Schalter T1 bis T4 zugeleitet. Die Magnetventile bzw. die Spulen L1 bis L4 sind über eine gemeinsame Versorgungsleitung 3 und über ein Relais Rel 1 an die elektrische Energiequelle, nämlich an eine Batterie mit der Spannung U_{B}, angeschlossen.

Außerdem ist an die Versorgungsleitung 3 eine Hilfs- oder Prüfspannungsquelle mit der Spannung U_{H} über einen hochohmigen Widerstand R₃ - hochohmig im Vergleich zu dem Innenwiderstand der Quelle U_{B} - angeschlossen.

Das Potential auf der Versorgungsleitung 3 wird bei der dargestellten Schaltungsanordnung nach der Erfindung mit Hilfe von zwei Potentialmonitoren PM1 und PM2, die über Spannungsteiler R₄, R₅ bzw. R₆, R₇ an die Versorgungsleitung 3 angeschlossen sind, festgestellt und überwacht.

Der erste Potentialmonitor PM1 ist hier als Analog/Digital-Wandler ausgebildet. Der Potentialverlauf am Eingang des Wandlers PM1 wird feinstufig in digitale Ausgangssignale umgesetzt, die über eine Mehrfachleitung 4 dem Mikrocontroller MC zur Auswertung zugeleitet werden.

Der zweite Potentialmonitor PM2 ist in Form eines Fensterkomparators mit umschaltbarer Schwelle realisiert. Zur Schwellenumschaltung dient ein Schalter TH5. Das Ausgangssignal des Fensterkomparators PM2 wird schließlich in einer Steuereinheit ST1 in ein Signal zur Betätigung des Halbleiter-Relais Rel.1 umgesetzt. Ein Ausgang des Mikrocontrollers MC führt über eine Leitung 5 zur Steuereinheit ST1, damit der Mikrocontroller MC beim Erkennen eines Defektes oder einer Fehlfunktion über die Steuereinheit ST1 das Relais Rel 1 ansteuern und damit die Stromversorgung zu den Spulen Ll bis L4 unterbrechen kann.

Ein weiterer Komparator TH6 dient zur Erkennung des Schaltzustandes bzw. der Schaltposition des Relais Rel 1.

Die dargestellte Überwachungs-Schaltungsanordnung nach der Erfindung arbeitet wie folgt:

Das Relais Rel 1 hat hier die Funktion des sogenannten Hauptrelais. Beim Betätigen der Zündung wird zunächst ein Kontakt K₁ des Relais Rel 1 geschlossen; bei einem elektronischen Relais wird der Kontakt durch den steuerbaren Innenwiderstand einer Halbleiterstrecke realisiert. Dies wird durch den Fensterkomparator bzw. den zweiten Potentialmonitor PM2 überwacht.

Bei geöffnetem Relaiskontakt K₁ ist das Potential am Eingang des Fensterkomparators PM2 "Low"; die Prüf- oder Hilfspannung U_{H} ist wesentlich niedriger als die Batteriespannung U_{B}, so daß der Einfluß der Spannungsquelle U_{H} auf die Spannung am Eingang des Monitors PM2 bzw. am Spannungsteiler R₆, R₇ vernachlässigt werden kann. Ist K₁ von Anfang an geschlossen - weil ein Kurzschluß vorliegt - wird dies sofort erkannt.

Nach dem Schließen des Relaiskontaktes K₁ steigt die Spannung am Eingang des Fensterkomparators PM2 über die durch die Spannung UH und die Widerstände R₈, R₉ vorgegebene Schwellenspannung am zweiten Eingang des Komparators an. Der Ausgang des Komparators schaltet auf "High". Wenn dies erfolgt ist, wird die Schwelle dieses Fensterkomparators mit dem Schalter TH5 auf einen höheren Wert gesetzt, so daß der Ausgang des Komparators wieder "Low" wird. Durch diese Low-High-Low-Übergänge wird gleichzeitig die Funktion des Fensterkomparators PM2 bei ordnungsgemäßer Funktion des Halbleiterrelais Rel 1 getestet. Nach dem Umschalten auf die höhere Schwelle dient der Fensterkomparator über die Steuereinheit ST1 zur Betätigung bzw. Abschaltung des Relais Rel 1 und damit der Regler beim Auftreten von Überspannungen an der U_{B}- Eingangsklemme (KL30).

Das Einschalten der Ventilspulen L1 bis L4 wird mit Hilfe von Testpulsen, die der Mikrocontroler MC über die Leitung 1 liefert, geprüft. Diese Testpulse sind so kurz, daß die Hydraulikventile, zu denen die Ventilspulen L1 bis L4 gehören, noch nicht ansprechen. Durch diese Testpulse wird jedoch der jeweilige Schalter T1 bis T4 geschlossen und damit eine Potentialänderung am Eingang des entsprechenden Komparators TH1 bis TH4 und an den Ansteueranschlüssen l₁ bis l₄ hervorrufen.

Außerdem wird durch die Testpulse der Kontakt K₁ des Halbleiterrelais Rel.1 geöffnet.

Wird keines der Hydraulikventile bzw. keine der Spulen L1 bis L4 angesteuert, muß bei offenem Kontakt K₁ des Relais Rel.1 am Eingang des Analog/Digital-Wandlers PM1 ein Potential anliegen, dessen Höhe von der Hilfs- oder Prüfspannung U_{H} und den Widerständen R₃, R₄, R₅, R₆ und R₇ abhängig ist. Ein Kurzschluß oder ein Leckstrom von der Versorgungsleitung 3 zur Masse würde das Potential am Eingang des Analog/Digital-Wandlers PM1 ändern. Die Höhe des Potentials am Eingang des Wandlers PM1 läßt Rückschlüsse auf die Höhe eines eventuellen Leckstroms zu. Ein geringer Leckstrom wäre sicherlich auf Dauer oder vorübergehend tolerierbar, während ein höherer Leckstrom auf einen schwerwiegenden Fehler hinweisen würde und damit das Abschalten der Regelung durch Betätigung des Relais Rel 1 bzw. Öffnen des Kontaktes K₁ zur Folge haben müßte.

Durch entsprechende Ansteuerung der einzelnen Endstufen oder Schalter T1 bis T4 und Auswertung der in Abhängigkeit von der Ansteuerung dieser Schalter eintretenden Potentialänderungen an den Eingängen der Komparatoren TH1 bis TH4 und am Eingang des ersten Spannungsmonitors oder Analog/Digital-Wandler PM1 läßt, wie ohne weiteres verständlich ist, Rückschlüsse auf den Ort bzw. die Quelle eventueller Fehler zu. Durch die Ansteuerung mit Testpulsen nach einem bestimmten Programm ist natürlich auch erkennbar, wenn eine Baustufe, z.B. ein Schalter T1 bis T4 oder ein Komparator TH1 bis TH4, das Schieberegister SR1 oder der Potentialmonitor PM1 fehlerhaft wird. Es werden also nicht nur die Ventilspulen L1 bis st = L4, sondern auch die Überwachungsschaltung selbständig auf Funktionsfähigkeit getestet.

Den Komparatoren TH1 bis TH4 ist über die Hilfsspannung U_{H} und den Spannungsteiler R₁, R₂ eine bestimmte Vorspannung oder Schwellspannung vorgegeben. Außerdem wird durch die Stromquellen Q1 bis Q4 ein gewisser Mindestwert an den entsprechenden Komparatoreingängen bei offenem Schalter T1 bis T4 eingestellt. Wird die von der Hilfsspannung U_{H} vorgegebene Schwelle unterschritten, liegt ein Kurzschluß gegen Masse vor. Auch dies wird erkannt und in dem Mikrocontroller MC zur Abschaltung der Regelung ausgewertet.

Die erfindungsgemäße Schaltungsanordnung wurde hier anhand einer Bremsanlage mit elektronischer Regelung dargestellt. Auf gleicher Weise lassen sich jedoch auch die Spulen anderer elektro-mechanischer Systeme, z.B. der Einspritzanlagen eines Fahrzeuges, überwachen. Es wird, wie aus dem Vorstehenden erkennbar ist, eine Vielzahl sehr unterschiedlicher Fehlerarten, einschließlich fehlerhafter Überwachungskomponenten, erfaßt.

## Patentansprüche

1. Schaltungsanordnung zur Überwachung einer Vielzahl von Spulen (L1 bis L4) und der Endstufen (T1 bis T4) zur Ansteuerung dieser Spulen, bei der die Spulen (L1 bis L4) über eine gemeinsame Versorgungsleitung (3) und über ein gemeinsames Relais (Rel 1) an die Versorgungsspannung (U_{B}) angeschlossen sind und bei der die Endstufen (T1 bis T4) nach einem vorgegebenen Programm mit Testpulsen angesteuert werden und die Potentialänderungen an den einzelnen Spulen-Ansteueranschlüssen (l₁-l₄) festgestellt werden, dadurch **gekennzeichnet**, daß die Versorgungsleitung (3) an einen ersten Potentialmonitor (PM1) und über einen hochohmigen Widerstand (R₃) an eine Prüfspannungsquelle (U_{H}) angeschlossen ist, wobei mit dem ersten Potentialmonitor (PM1) nach dem Unterbrechen der Spannungsversorgung (U_{B}) bzw. nach dem Öffnen des Relais (Rel 1) bzw. des Relaiskontaktes das auf der Versorgungsleitung (3) herrschende Potential feststellbar ist.

2. Schaltungsanordnung nach Anspruch 1, dadurch **gekennzeichnet**, daß an die Versorgungsleitung (3) ein zweiter Potentialmonitor (PM2) angeschlossen ist, der beim Einschalten der Spannungsversorgung (U_{B}) die ordnungsgemäße Potentialänderung auf der Versorgungsleitung (3) infolge der Relaisbetätigung (Rel 1) überwacht.

3. Schaltungsanordnung nach Anspruch 1 oder 2, dadurch **gekennzeichnet**, daß die Spannungsmonitore (PM1, PM2) über Spannungsteiler (R₄, R₅; R₆, R₇) an die Versorgungsleitung (3) angeschlossen sind.

4. Schaltungsanordnung nach einem oder mehreren der Ansprüche 1 oder 3, dadurch **gekennzeichnet**, daß als Relais (Rel 1) zum Ein- und Ausschalten der Versorgungsspannung (U_{B}) ein Halbleiter-Relais vorgesehen ist.

5. Schaltungsanordnung nach einem oder mehreren der Ansprüche 1 oder 4, dadurch **gekennzeichnet**, daß als erster Potentialmonitor (PM1) ein Analog/Digital-Wandler vorgesehen ist.

6. Schaltungsanordnung nach einem oder mehreren der Ansprüche 1 oder 5, dadurch **gekennzeichnet**, daß als zweiter Potentialmonitor (PM2) ein Fensterkomparator mit umschaltbarer Schwelle vorgesehen ist, wobei nach dem Einschalten der Versorgungsspannung (U_{b}) und Überschreiten eines ersten Schwellwertes das Umschalten auf einen zweiten Schwellwert erfolgt und als Kriterium für die ordnungsgemäße Funktion des Fensterkomparators ausgewertet wird.

7. Schaltungsanordnung nach Anspruch 5, dadurch **gekennzeichnet**, daß die Potentialänderung am Eingang des ersten Potentialmonitors (PM1) in Abhängigkeit von der Betätigung des Relais (Rel 1) zum Überprüfen der Funktionsfähigkeit des ersten Potentialmonitors (PM1) ausgewertet wird.

8. Schaltungsanordnung nach einem oder mehreren der Ansprüche 1 bis 7, dadurch **gekennzeichnet**, daß bei der Ansteuerung der einzelnen Endstufen (T1 - T4) durch die Testpulse die jeweilige Potentialänderung an den Spulen-Ansteueranschlüssen (l₁ .. l₄) mit den Potentialänderungen am Eingang des ersten Potentialmonitors (PM1; A/D-Wandlers) verglichen und zur Überwachung bzw. zur Fehlererkennung ausgewertet wird.

9. Schaltungsanordnung nach einem oder mehreren der Ansprüche 1 bis 8, dadurch **gekennzeichnet**, daß die Spulen (L1 bis L4) Ventilspulen einer geregelten Bremsanlage sind.

## Claims

1. A circuit configuration for monitoring a plurality of coils (L1 to L4) and the final stages (T1 to T4) to actuate the coils, wherein the coils (L1 to L4) are connected to the supply voltage (U_{B}) by way of a joint supply line (3) and a joint relay (Rel 1), and wherein the final stages (T1 to T4) are driven by test pulses according to a predetermined program and the potential changes at the individual coil actuating connections (l₁ to l₄) are detected,
**characterized** in that the supply line (3) is connected to a first potential monitor (PM1) and is connected to a test voltage source (U_{H}) by way of a high-ohmic resistor (R₃), and the first potential monitor (PM1) permits determining the potential prevailing on the supply line (3) after the voltage supply (U_{B}) has been interrupted or the relay (Rel 1) or the relay contact has been opened.

2. A circuit configuration as claimed in claim 1,
**characterized** in that a second potential monitor (PM2) is connected to the supply line (3) and, upon activation of the supply voltage (U_{B}), monitors the proper potential change on the supply line (3) due to the operation of the relay (Rel 1).

3. A circuit configuration as claimed in claim 1 or claim 2,
**characterized** in that the voltage monitors (PM1, PM2) are connected to the supply line (3) by way of voltage dividers (R₄, R₅; R₆, R₇).

4. A circuit configuration as claimed in any one or more of claims 1 or 3,
**characterized** in that a semiconductor relay for activating and deactivating the supply voltage (U_{B}) is provided as relay (Rel 1).

5. A circuit configuration as claimed in any one or more of claims 1 or 4,
**characterized** in that an analog/digital converter is provided as a first potential monitor (PM1).

6. A circuit configuration as claimed in any one or more of claims 1 or 5,
**characterized** in that, as a second potential monitor (PM2), a window comparator with a reswitchable threshold is provided, the switch-over to a second threshold value taking place after the supply voltage (U_{B}) is activated and a first threshold value is exceeded, the switch-over being assessed as a criterion for the proper function of the window comparator.

7. A circuit configuration as claimed in claim 5,
**characterized** in that the potential change at the input of the first potential monitor (PM1) is assessed, in response to the actuation of the relay (Rel 1), for checking the operability of the first potential monitor (PM1).

8. A circuit configuration as claimed in any one or more of claims 1 to 7,
**characterized** in that, during actuation of the individual final stages (T1 to T4) by the test pulses, the respective potential change at the coil actuating connections (l₁ ... l₄) is compared with the potential changes at the input of the first potential monitor (PM1; A/D converter) and assessed for monitoring and for error detection.

9. A circuit configuration as claimed in any one or more of claims 1 to 8,
**characterized** in that the coils (L1 to L4) are valve coils of a controlled brake system.

## Revendications

1. Montage pour le contrôle d'une multiplicité de bobines (L1 à L4) et des étages finals (T1 à T4) utilisés pour la commande de ces bobines, et dans lequel les bobines (L1 à L4) sont raccordées par l'intermédiaire d'une ligne d'alimentation commune (3) et d'un relais commun (Rel 1) à la tension d'alimentation (UB) et dans lequel les étages finals (T1 à T4) sont commandés par des impulsions de test, selon un programme prédéterminé, et les variations de potentiel sur les différentes bornes (L1-L4) de commande de bobines sont déterminées, caractérisé en ce que la ligne d'alimentation (3) est raccordée à un premier dispositif (PM1) de contrôle de potentiel et par l'intermédiaire d'une résistance de forte valeur ohmique (R3) à une source de tension de contrôle (UH), le potentiel régnant dans la ligne d'alimentation (3) pouvant être déterminé avec le premier dispositif (PM1) de contrôle du potentiel après interruption de l'alimentation de tension (UB) ou après l'ouverture du relais (Rel 1) ou du contact du relais.

2. Montage selon la revendication 1, caractérisé en ce qu'à la ligne d'alimentation (3) est raccordé un second dispositif (PM2) de contrôle de potentiel, qui, lors de l'application de la tension d'alimentation (UB), contrôle la variation correcte du potentiel dans la ligne d'alimentation (3) sous l'effet de l'actionnement du relais (Rel 1).

3. Montage selon la revendication 1 ou 2, caractérisé en ce que les dispositifs (PM1, PM2) de contrôle de tension sont raccordés à la ligne d'alimentation (3) par l'intermédiaire de diviseurs de tension (R4, R5; R6, R7).

4. Montage selon une ou plusieurs des revendications 1 ou 3, caractérisé en ce qu'un relais à semiconducteurs est prévu en tant que relais (Rel 1) pour l'application et la suppression de la tension d'alimentation (UB).

5. Montage selon une ou plusieurs des revendications 1 ou 4, caractérisé en ce qu'un convertisseur analogique/numérique est prévu en tant que premier dispositif (PM1) de contrôle de potentiel.

6. Montage selon une ou plusieurs des revendications 1 ou 5, caractérisé en ce qu'il est prévu, comme second dispositif (PM2) de contrôle de potentiel, un comparateur à fenêtre comportant un seuil commutable, auquel cas après l'application de la tension d'alimentation (Ub) et le dépassement d'une première valeur de seuil, la commutation sur une seconde valeur de seuil est exécutée et est évaluée comme critère pour le fonctionnement correct du comparateur à fenêtre.

7. Montage selon la revendication 5, caractérisé en ce que la variation de potentiel à l'entrée du premier dispositif (PM1) de contrôle de potentiel est exploitée en fonction de l'actionnement du relais (Rel 1) pour le contrôle de l'aptitude au fonctionnement du premier dispositif (PM1) de contrôle de potentiel.

8. Montage selon une ou plusieurs des revendications 1 à 7, caractérisé en ce que dans le cas de la commande des différents étages finals (T1-T4) par les impulsions de test, la variation respective de potentiel au niveau des bornes (l1...l4) de commande des bobines est comparée aux variations de potentiel à l'entrée du premier dispositif (PM1; convertisseur analogique/numérique) de contrôle du potentiel et est exploitée pour le contrôle ou pour l'identification de défauts.

9. Montage selon une ou plusieurs des revendications 1 à 8, caractérisé en ce que les bobines (L1 à L4) sont des bobines de soupapes d'une installation de freinage réglée.
